Europäisches Patentamt

European Patent Office

Office européen des brevets

(19)

(11) Numéro de publication : **0 069 656**
**B1**

(12) **FASCICULE DE BREVET EUROPÉEN**

(45) Date de publication du fascicule du brevet :
30.10.85

(21) Numéro de dépôt : 82401231.4

(22) Date de dépôt : 01.07.82

(51) Int. Cl.⁴ : **H 05 K 13/04, H 05 K 13/02**

(54) **Dispositif pour insérer des contacts sur une plaquette de support.**

(30) Priorité : 03.07.81 FR 8113367

(43) Date de publication de la demande :
12.01.83 Bulletin 83/02

(45) Mention de la délivrance du brevet :
30.10.85 Bulletin 85/44

(84) Etats contractants désignés :
BE CH DE GB IT LI

(56) Documents cités :
FR-A- 2 234 737

(73) Titulaire : COMATEL Société Anonyme:
40, rue de Montlhéry Silic 148
F-93523 Rungis Cedex (FR)

(72) Inventeur : Cabaud, Aimé
28, rue de Villacoublay
F-78140 Velizy (FR)

(74) Mandataire : Boivin, Claude
9, rue Edouard-Charton
F-78000 Versailles (FR)

## Description

La présente invention a pour objet un dispositif pour insérer un ensemble de contacts sur des plaquettes de support de circuits hybrides ou de plaquettes de circuits imprimés, selon la première partie de la revendication 1.

On connaît des ensembles de contacts à souder pour circuit hybride ou plaquette de circuit imprimé reliés par deux bandes latérales, dans lesquels les contacts comportent chacun, à l'une de leurs extrémités, une pince orientée perpendiculairement au plan des contacts et propre à s'engager sur un circuit hybride, et qui sont reliés initialement l'un à l'autre à chacune de leurs extrémités.

Le dispositif selon l'invention est caractérisé en ce qu'il comprend un support de plaquette fixe, un bâti mobile dans la direction longitudinale du support fixe et sur lequel sont montés mobiles deux galets à rappel élastique formant galets de renvoi pour les ensembles de contact, les pinces des contacts se trouvant au niveau de la plaquette placée sur ce support fixe, un vérin pour déplacer ce bâti mobile, et des moyens pour solidariser les ensembles des contacts alternativement avec le support fixe et avec le bâti mobile.

Pour utiliser ce dispositif, on place une plaquette sur le support fixe, on solidarise les ensembles de contact avec ce support de sorte que ces ensembles sont immobilisés, et on déplace vers le support le bâti mobile qui entraîne les galets. Ceux-ci pressent sur les bords de la plaquette placée sur le support les ensembles de contact dont les pinces viennent progressivement s'engager sur ces bords. En fin de mouvement, on désolidarise du support fixe les ensembles de contact, on solidarise ces ensembles et le bâti mobile, et on ramène à sa position initiale ce bâti qui entraîne les ensembles de contact et la plaquette insérée entre ces ensembles. On recommence ensuite le cycle d'opérations qui vient d'être décrit.

Les moyens pour solidariser les ensembles de contact avec le support fixe et avec le bâti mobile sont avantageusement constitués par des vérins respectivement fixe et porté par le bâti mobile, et propres à commander des doigts pouvant s'engager dans des trous prévus dans les ensembles de contact.

On a décrit ci-après, à titre d'exemple non limitatif, un mode de réalisation du dispositif selon l'invention, avec référence au dessin annexé dans lequel :

la figure 1 est une vue en élévation d'une partie d'un ensemble de contacts ;

la figure 2 est une vue en coupe de cet ensemble et montre la pince d'un contact engagée sur une plaquette de support d'un circuit hybride ;

les figures 3 et 4 sont des vues en plan du dispositif dans deux positions différentes.

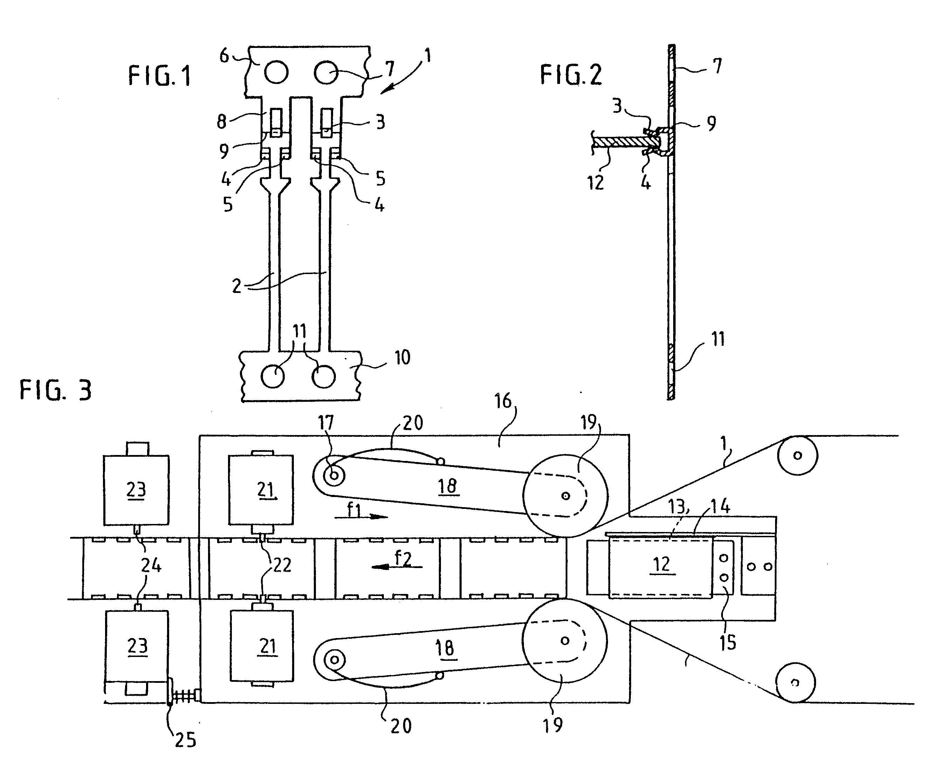

Aux figures 1 et 2, on voit un ensemble 1 de contact 2. Chacun de ces contacts comprend un corps allongé terminé à l'une de ses extrémités par une pince qui est orientée perpendiculairement à l'axe du corps ; cette pince est formée d'une lamelle élastique centrale 3, et de deux lamelles 4 et 5, qui longitudinalement sont écartées de la lamelle 3, et transversalement sont disposées de part et d'autre de cette lamelle. Les contacts 2 sont reliés, à leurs extrémités comportant la pince, par une bande 6 munie d'un trou 7 dans l'axe de chacun des contacts 2 ; la liaison entre la bande et le contact est assurée par l'intermédiaire de portions 8, de largeur réduite, et une amorce de rupture 9 est prévue à l'extrémité du contact 2, au voisinage immédiat de la lamelle 3. Par ailleurs, à leurs extrémités opposées, les contacts 2 sont réunis par une bande 10 percée d'un trou 11 en regard de chaque contact. Les trous 7 et 11 ont notamment pour but de permettre l'avance de la bande 1 d'une part, lors de la fabrication des contacts et d'autre part lors de la mise en place des contacts sur une plaquette 12 formant support pour un circuit hybride.

Le dispositif selon l'invention a pour but d'insérer deux ensembles de contacts 1 de chaque côté opposé d'une série de plaquettes 12.

Ce dispositif comprend un support fixe 13 sur lequel on peut placer une plaquette 12 et qui porte une butée d'extrémité 15 pour cette plaquette. Un bâti 16 est monté mobile parallèlement à la direction longitudinale du support 13 et est relié à la tige du piston d'un vérin de commande non représenté ; ce bâti porte des butées latérales 14 pour la plaquette 12.

Sur le bâti 16 sont articulés en 17 deux leviers 18 à l'extrémité de chacun desquels est monté en rotation un galet 19 servant de guidage à une bande 1. Ces galets sont disposés de manière que les pinces des contacts se trouvent au niveau d'une plaquette 12 placée sur le support 13. Les leviers 18 sont soumis à l'action des ressorts 20 qui tendent à appliquer les galets 19 sur les bandes 1 et, par suite, ces bandes sur la plaquette 12 placée sur le support 13.

Sur l'extrémité du bâti 16 opposée au support 13 sont montés deux vérins 21 dont les tiges de piston portent des doigts 22 pouvant s'engager chacun dans un trou 11 d'une bande 10. Deux vérins fixes 23 sont prévus à proximité des vérins 21 ; la tige de piston de chacun d'eux porte un doigt 24 pouvant s'engager dans un trou 11.

A la figure 3, les doigts 22 sont engagés dans des trous 11 ; par contre, les doigts 24 sont dégagés des trous 11.

On pose une plaquette 12 sur le support 13 et on inverse les positions des vérins 21 et 23, de sorte que les doigts 24 s'engagent dans des trous 11 et que les doigts 22 s'en dégagent. Puis on actionne le vérin de commande du support 16, de sorte que celui-ci se déplace dans le sens de la flèche $f_1$.

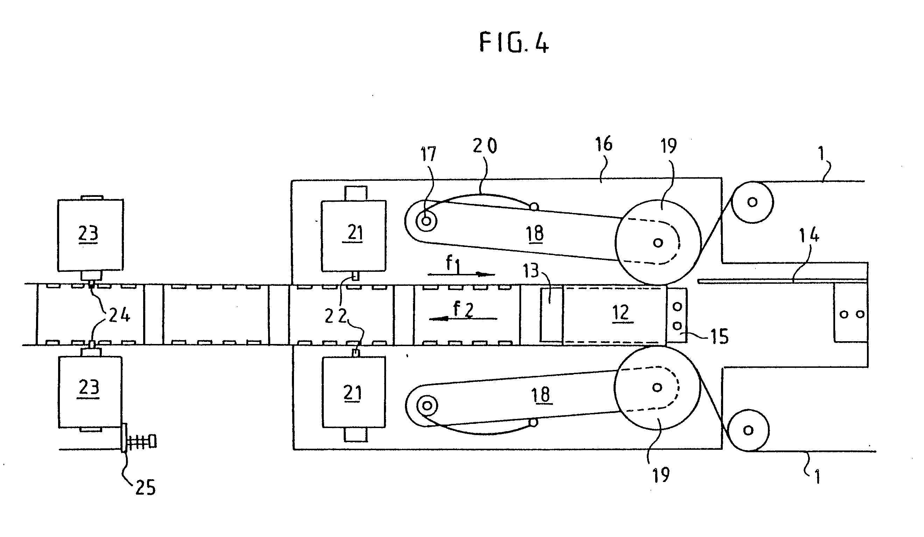

Par suite de ce mouvement, les galets 19 appliquent sur la plaquette 12 immobilisée axialement par la butée 15, les bandes 1 dont les pinces 3-4-5 viennent s'insérer sur les bords de la plaquette. En fin de course du vérin, la plaquette 12 est montée sur toute sa longueur, dans les pinces des contacts (Figure 4).

Il ne reste plus qu'à inverser à nouveau les positions des vérins 21 et 23 de sorte que les doigts 24 se dégagent des trous 11 et que les doigts 22 s'engagent dans ces trous, ce qui solidarise les bandes 1 et le bâti 16, et à ramener ce bâti dans sa position initiale. Le bâti entraîne dans le sens de la flèche $f_2$ opposé à celui de la flèche $f_1$, les bandes qui entraînent à leur tour la plaquette 12 venant d'être insérée entre elles. La course du bâti 16 est déterminée, par exemple, par une butée 25 réglable de façon que, après insertion des plaquettes dans les pinces des ensembles de contacts, les plaquettes soient légèrement écartées les unes des autres.

On procède ensuite à l'insertion d'une nouvelle plaquette en répétant les opérations qui viennent d'être décrites.

**Revendications**

1. Dispositif pour insérer sur une plaquette (12) d'un circuit hybride ou de circuit imprimé des contacts reliés entre eux de façon à former un ensemble, ces contacts comportant chacun, à l'une de leurs extrémités, une pince (3, 4, 5) orientée perpendiculairement au plan des contacts et propre à s'engager sur la plaquette (12), caractérisé en ce qu'il comprend un support de plaquette fixe (13), un bâti (16) qui est mobile dans la direction longitudinale du support fixe (13) et sur lequel sont montés mobiles deux galets (19) à rappel élastique (20) formant galets de renvoi pour les ensembles de contact, les pinces des contacts se trouvant au niveau de la plaquette (12) placée sur ce support fixe (13), un vérin pour déplacer ce bâti mobile (16), et des moyens (23, 21) pour solidariser les ensembles de contacts (2) alternativement avec le support fixe (13) et avec le bâti mobile (16).

2. Dispositif selon la revendication 1, caractérisé en ce que les moyens pour solidariser les ensembles de contacts avec le support fixe et avec le bâti mobile sont constitués par des vérins (23 et 21) respectivement fixe et porté par le bâti mobile, et propres à commander des doigts (24 et 22) pouvant s'engager dans des trous (11) prévus dans les bandes (10) des ensembles de contacts.

3. Dispositif selon la revendication 1 ou 2, caractérisé en ce que les galets (19) sont montés à rotation sur des leviers (18) articulés sur le bâti mobile et soumis à l'action de ressorts (20) tendant à les faire pivoter dans le sens correspondant à l'engagement des pinces des ensembles de contacts sur les bords d'une plaquette.

**Claims**

1. A device for inserting on a wafer (12) of a hybrid circuit or printed circuit contacts connected together so as to form an assembly, these contacts each comprising, at one of their ends, a clip (3, 4, 5) orientated perpendicularly to the plane of the contacts and adapted for engagement on the wafer (12), characterized in that it comprises a fixed wafer support (13), a frame (16) which is mobile in the longitudinal direction of the fixed support (13) and on which are movably mounted two resilient return rollers (19) forming change of direction rollers for the contact assemblies, the clips of the contacts being at the level of the wafer (12) placed on this fixed support (13), a hydraulic cylinder for moving this mobile frame (16) and means (23, 21) for securing the contact assemblies (2) alternately to the fixed support (13) and to the mobile frame (16).

2. The device according to claim 1, characterized in that the means for securing the contact assemblies to the fixed support and to the mobile frame are formed by hydraulic cylinders (23 and 21) respectively fixed and supported by the mobile frame, and adapted for controlling fingers (24 and 22) engageable in holes (11) provided in the contact assembly strips (10).

3. Device according to claim 1 or 2, characterized in that the rollers (19) are rotatably mounted on levers (18) mounted for pivoting on the mobile frame and subjected to the action of springs (20) tending to cause them to pivot in the direction corresponding to engagement of the contact assembly clips on the edges of the wafer.

**Patentansprüche**

1. Vorrichtung zum Anbringen von zu einer zusammenhängenden Einheit miteinander verbundenen Kontakten an einem Plättchen (12) eines Hybridschaltkreises oder eines gedruckten Schaltkreises, wobei jeder dieser Kontakte an einem seiner Enden eine senkrecht zur Ebene der Kontakte orientierte Klemme (3, 4, 5), die zum Aufschieben auf das Plättchen geeignet ist, aufweist, dadurch gekennzeichnet, daß sie eine feste Auflage (13) für Plättchen aufweist und ein in Längsrichtung der festen Auflage (13) bewegbares Gestell (16), auf dem zwei Rollen (19) bewegbar mit elastischer Rückholung angeordnet sind, die Umlenkrollen für die Kontakteinheiten bilden, wobei sich die Kontaktklemmen auf der Höhe des auf die feste Auflage (13) aufgelegten Plättchens befinden, sowie eine Winde zum Verschieben dieses bewegbaren Gestells (16) und Mittel (23, 21), um die Kontakteinheiten (2) abwechselnd mit der festen Auflage (13) und dem bewegbaren Gestell (16) kraftschlüssig zu verbinden.

2. Vorrichtung nach Anspruch 1, dadurch gekennzeichnet, daß die Mittel zum kraftschlüssigen Verbinden der Kontakteinheiten mit der festen Auflage und mit dem bewegbaren Gestell als Winden (23, 21) ausgebildet sind, die jeweils fest bzw. am bewegbaren Gestell angeordnet sind und geeignet sind, Finger (24 und 22) zu betätigen, welche in an den Rändern (10) der Kontakteinheiten vorgesehene Löcher (11) eingreifen können.

3. Vorrichtung nach Anspruch 1 oder 2, dadurch gekennzeichnet, daß die Rollen (19) drehbar an Hebeln (18) angeordnet sind, welche schwenkbar am bewegbaren Gestell angeordnet sind und der Wirkung von Federn (20) unterworfen sind, die die Tendenz haben, sie in der Richtung entsprechend dem Aufschieben der Klemmen der Kontakteinheiten auf die Ränder eines Plättchens zu schwenken.

FIG.1

FIG.2

FIG. 3

FIG. 4